# EUROPEAN PATENT APPLICATION

(11) **EP 4 542 628 A1**
(43) Date of publication of application: **23.04.2025**
(21) Application number: 24198650.4
(22) Date of filing: 05.09.2024
(51) Int. Cl.: H01L 21/311, H01L 21/306

(54) **METHOD OF PROCESSING SUBSTRATE, METHOD OF MANUFACTURING SEMICONDUCTOR DEVICE, SUBSTRATE PROCESSING APPARATUS, AND PROGRAM**

(30) Priority: 05.10.2023 JP 2023173802
(71) Applicant: Kokusai Electric Corporation, Tokyo 101-0045 (JP)
(72) Inventor: USUKI, Kenshiro, Toyama-shi, Toyama, 939-2393 (JP); IKEDA, Yuma, Toyama-shi, Toyama, 939-2393 (JP); NAKAGAWA, Ryuichi, Toyama-shi, Toyama, 939-2393 (JP); YAMAZAKI, Hirohisa, Toyama-shi, Toyama, 939-2393 (JP)
(74) Representative: Bardehle Pagenberg Partnerschaft mbB Patentanwälte Rechtsanwälte

(57) **Abstract**

There is provided a technique that includes: removing a portion of a substance Y from a substrate (200) by performing a cycle a predetermined number of times, the cycle including: (a1) supplying a first gas containing a first halogen element to the substrate (200), including a surface of the substance Y containing an element X, to form a first product, containing the first halogen element and the element X, on the substrate (200); and (b 1) supplying a second gas containing a second halogen element to the substrate (200) to convert a portion of the first product into a second product containing the element X and having a higher vapor pressure than the first product, wherein (b 1) is performed under a condition where a portion of the substance Y is removable from the substrate (200) when the second gas is supplied to the substance Y not containing the first halogen element on the surface.

## Description

### CROSS-REFERENCE TO RELATED APPLICATION

This application is based upon and claims the benefit of priority from Japanese Patent Application No. 2023-173802, filed on October 5, 2023, the entire contents of which are incorporated herein by reference.

### TECHNICAL FIELD

The present disclosure relates to a method of processing a substrate, a method of manufacturing a semiconductor device, a substrate processing apparatus, and a program.

### BACKGROUND

In the related art, as a manufacturing process of semiconductor devices, there is a step where a film is etched by executing a cycle of supplying different types of gases a predetermined number of times.

### SUMMARY

Some embodiments of the present disclosure provide a technique capable of improving controllability of an etching amount.

According to embodiments of the present disclosure, there is provided a technique that includes: removing a portion of a substance Y from the substrate by performing a cycle a predetermined number of times, the cycle including: (a1) supplying a first gas containing a first halogen element to the substrate, which includes a surface of the substance Y containing an element X, to form a first product, which contains the first halogen element and the element X, on the substrate; and (b 1) supplying a second gas containing a second halogen element to the substrate to convert at least a portion of the first product into a second product containing the element X and having a higher vapor pressure than the first product, wherein (b 1) is performed under a condition in which at least a portion of the substance Y is removable from the substrate when the second gas is supplied to the substance Y that does not contain the first halogen element on the surface.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus suitably used in embodiments of the present disclosure, and is a diagram illustrating a portion of the process furnace in a vertical cross-sectional view.
FIG. 2 is a schematic configuration diagram of a controller of the substrate processing apparatus suitably used in the embodiments of the present disclosure, and is a diagram illustrating a control system of the controller in a block diagram.
FIG. 3 is a flowchart illustrating a substrate processing process according to the embodiments of the present disclosure.
FIG. 4A is an image diagram when a first gas is supplied to a recess on a substrate. FIG. 4B is an image diagram when a surface of a substance on the substrate is converted into a first product by the first gas. FIG. 4C is an image diagram when a second gas is supplied to the substrate in the state of FIG. 4B. FIG. 4D is an image diagram when a portion of the first product is converted into a second product, which possesses a higher vapor pressure than the first product.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of Present Disclosure>

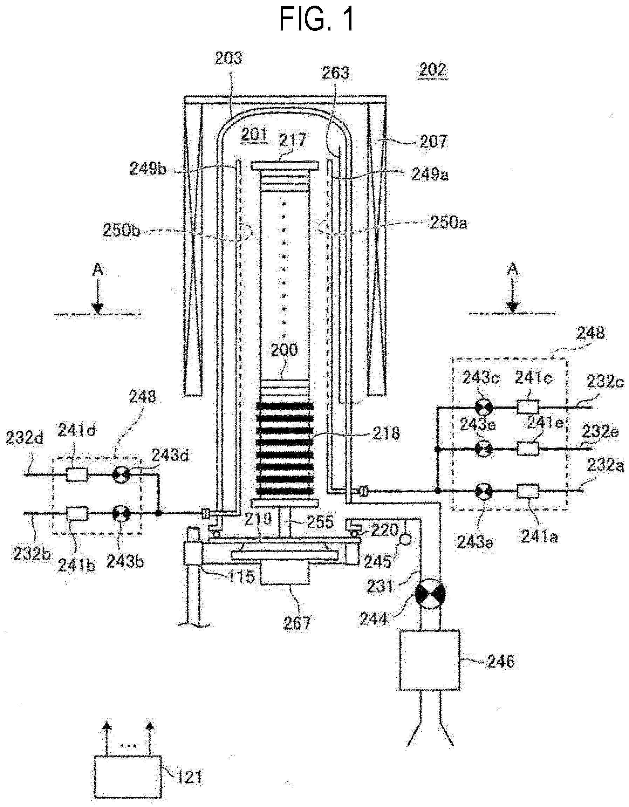

Hereinafter, embodiments of the present disclosure are described mainly with reference to FIGS. 1 to 4D. In addition, the drawings used in the following description are all schematic, and dimensional relationships among respective components and proportions of respective components illustrated in the drawings may not correspond to the actual ones. Further, the dimensional relationships among respective components and the proportions of respective components, and the like may not match among multiple drawings.

### (1) Configuration of Substrate Processing Apparatus

As illustrated in FIG. 1, a process furnace 202, which serves as a substrate processing apparatus, includes a heater 207, which serves as a heating system (temperature regulator). The heater 207 also functions as an activator (exciter) that activates (excites) a gas with heat. A reaction tube 203 is disposed inside the heater 207. A process chamber 201 capable of accommodating wafers 200, serving as substrates, is formed in a cylindrical hollow region of the reaction tube 203. The wafer 200 is processed within the process chamber 201. Nozzles 249a and 249b are provided within the process chamber 201 to penetrate a lower sidewall of the reaction tube 203. Gas supply pipes 232a and 232b are respectively connected to the nozzles 249a and 249b.

The gas supply pipes 232a and 232b are provided, respectively, with mass flow controllers (MFCs) 241a and 241b, which serve as flow rate controllers (flow rate control parts), and valves 243a and 243b, which serve as opening/closing valves, in order from an upstream side. Each of gas supply pipes 232c and 232e is connected to the gas supply pipe 232a at a downstream side of the valve 243a. A gas supply pipe 232d is connected to the gas supply pipe 232b at a downstream side of the valve 243b. The gas supply pipes 232c, 232d and 232e are provided, respectively, with MFCs 241c, 241d and 241e and valves 243c, 243d and 243e in order from an upstream side of gas flow.

The nozzles 249a and 249b are provided in a space of an annular shape in a plane view between an inner wall of the reaction tube 203 and the wafers 200 so as to extend upward in an arrangement direction of the wafers 200 from a lower portion to an upper portion of the inner wall of the reaction tube 203. Gas supply holes 250a and 250b for supplying gases are respectively provided on side surfaces of the nozzles 249a and 249b. The gas supply holes 250a and 250b are open to face a center of the reaction tube 203, respectively, which enables supply of gases toward the wafers 200. A plurality of gas supply holes 250a and 250b are provided from a lower portion to an upper portion of the reaction tube 203.

A first gas containing a first halogen element is supplied from the gas supply pipe 232a into the process chamber 201 through the MFC 241a, valve 243a, and nozzle 249a.

A second gas containing a second halogen element is supplied from the gas supply pipe 232b into the process chamber 201 through the MFC 241b, valve 243b, and nozzle 249b.

An inert gas is supplied from the gas supply pipes 232c and 232d into the process chamber 201 through the MFCs 241c and 241d, valves 243c and 243d, gas supply pipes 232a and 232b, and nozzles 249a and 249b. The inert gas acts as a purge gas, a carrier gas, a dilution gas, and others.

A modifying agent is supplied from the gas supply pipe 232e into the process chamber 201 through the MFC 241e, valve 243e, gas supply pipe 232a, and nozzle 249a. The term "agent" as used herein includes at least one selected from the group of a gaseous substance and a liquid substance. In addition, the liquid substance includes a mist-like substance. In other words, the modifying agent may contain a gaseous substance, may contain a liquid substance such as mist-like substance, or may contain both.

A first gas supply system for supplying the first gas is mainly constituted by the gas supply pipe 232a, MFC 241a, and valve 243a. A second gas supply system for supplying the second gas is mainly constituted by the gas supply pipe 232b, MFC 241b, and valve 243b. An inert gas supply system for supplying the inert gas is mainly constituted by the gas supply pipes 232c and 232d, MFCs 241c and 241d, and valves 243c and 243d. A modifying agent supply system for supplying the modifying agent is mainly constituted by the gas supply pipe 232e, MFC 241e, and valve 243e.

Any of or the entire various supply systems described above may be configured as an integrated supply system 248 where the valves 243a to 243e, MFCs 241a to 241e, and others are integrated. The integrated supply system 248 is connected to each of the gas supply pipes 232a to 232e, and is configured to control, by a controller 121 to be described later, supply operations of various gases into the gas supply pipes 232a to 232e such as opening/closing operations of the valves 243a to 243e and flow rate regulating operations by the MFCs 241a to 241e.

An exhaust pipe 231 is provided at a lower portion of the sidewall of the reaction tube 203 to exhaust an atmosphere in the process chamber 201. The exhaust pipe 231 is connected to a vacuum pump 246, which serves as an vacuum exhauster, through a pressure sensor 245, which serves as a pressure detector (pressure detection part) that detects a pressure inside the process chamber 201, and an APC (Auto Pressure Controller) valve 244, which serves as a pressure regulator (pressure regulation part). The APC valve 244 is configured to perform vacuum-exhaust of the inside of the process chamber 201 or stop the vacuum-exhaust by being opened or closed while the vacuum pump 246 is in operation. The APC valve 244 is also configured to regulate the pressure inside the process chamber 201 by adjusting the opening degree thereof based on pressure information detected by the pressure sensor 245 while the vacuum pump 246 is in operation. An exhaust system is mainly constituted by the exhaust pipe 231, pressure sensor 245, and APC valve 244. The vacuum pump 246 may also be included in the exhaust system.

A seal cap 219 capable of airtightly closing a lower end opening of the reaction tube 203 is provided below the reaction tube 203. An O-ring 220 is provided on an upper surface of the seal cap 219 and serves as a sealing member that abuts against a lower end of the reaction tube 203. A rotator 267 is installed below the seal cap 219 to rotate a boat 217 to be described later. A rotating shaft 255 of the rotator 267 passes through the seal cap 219 and is connected to the boat 217. The rotator 267 is configured to rotate the wafer 200 by rotating the boat 217. The seal cap 219 is configured to be vertically raised or lowered by a boat elevator 115, which serves as a lift installed outside the reaction tube 203. The boat elevator 115 is configured as a transporter (transport mechanism) that loads and unloads (transports) the wafer 200 into and out of the process chamber 201 by raising or lowering the seal cap 219.

The boat 217 serving as a substrate support is configured to support a plurality of wafers 200, e.g., "25 to 200" wafers, in such a state that the wafers 200 are arranged in a horizontal posture and in multiple stages along a vertical direction with centers of the wafers 200 aligned with one another. That is, the boat 217 is configured to arrange the wafers 200 to be spaced apart from one another. Heat insulating plates 218 are supported in multiple stages in a horizontal posture at a lower portion of the boat 217. In addition, the notation of numerical ranges such as "25 to 200" in the present disclosure refers that both the lower and upper limits are included in that range. Thus, for example, "25 to 200" refers to "25 or more and 200 or less." The same applies to other numerical ranges.

A temperature sensor 263 is installed as a temperature detector within the reaction tube 203. It is configured such that a temperature in the process chamber becomes a desired temperature distribution by regulating a state of electric power supplied to the heater 207 based on temperature information detected by the temperature sensor 263.

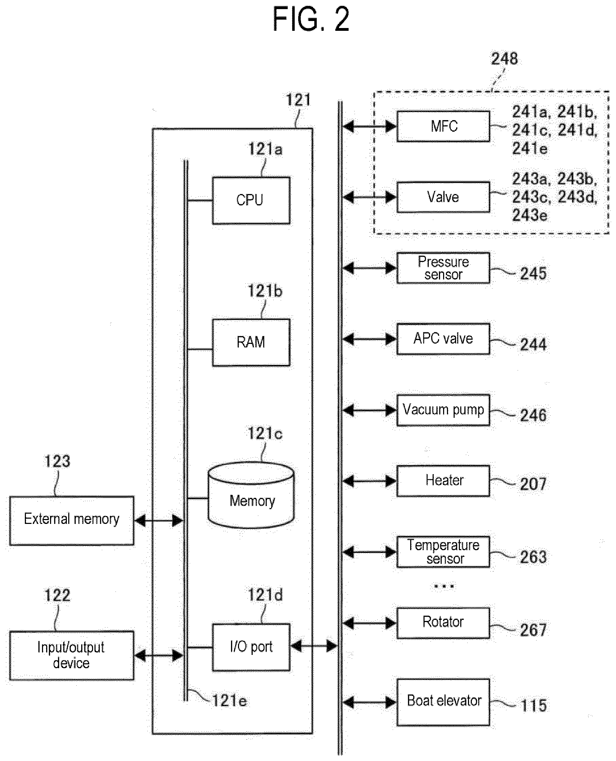

As illustrated in FIG. 2, the controller 121, which is a control part (control means), is configured as a computer including a CPU(Central Processing Unit) 121a, RAM(Random Access Memory) 121b, memory 121c, and I/O port 121d. The RAM 121b, memory 121c, and I/O port 121d are configured to be capable of exchanging data with the CPU 121a via an internal bus 121e. An input/output device 122, which is configured as, for example, a touch panel or the like, is connected to the controller 121. Further, it is possible to connect an external memory 123 to the controller 121. In addition, the substrate processing apparatus may be configured to include a single controller or a plurality of controllers. In other words, control for performing a substrate processing sequence to be described later may be performed using a single controller, or a plurality of controllers. When the term "controller" is used herein, it may refer to a case including a single controller, or a case of including a plurality of controllers.

The memory 121c is composed of, for example, a flash memory, a HDD (Hard Disk Drive), and others. The memory 121c stores, in a readable manner, control programs for controlling operations of the substrate processing apparatus, process recipes in which procedures, conditions, and others of etching to be described later are written, and others. The process recipes are combinations that enables the controller 121 to execute each procedure in the etching to be described later, resulting in predetermined results, and function as programs. Hereinafter, the process recipes, control programs, and others are collectively referred to simply as "programs." Further, the process recipes may be simply referred to as "recipes." The term "programs" as used herein may refer to a case of solely including the recipes, a case of solely including the control programs, or a case of including both. The RAM 121b is configured as a memory area (work area) where programs, data, and others read by the CPU 121a are temporarily held.

The I/O port 121d is connected to the above-described MFCs 241a to 241e, valves 243a to 243e, pressure sensor 245, APC valve 244, vacuum pump 246, temperature sensor 263, heater 207, rotator 267, boat elevator 115, and others.

The CPU 121a is configured to read and execute the control programs from the memory 121c, and is configured to read the recipes from the memory 121c, in response to an input of an operation command and the like from the input/output device 122. The CPU 121a is configured to, according to contents of the process recipe thus read, enable the control the flow rate regulating operations of various gases by the MFCs 241a to 241e, the opening/closing operations of the valves 243a to 243e, the opening/closing operation of the APC valve 244, the pressure regulating operation by the APC valve 244 based on the pressure sensor 245, the startup and shutdown of the vacuum pump 246, the temperature regulating operation of the heater 207 based on the temperature sensor 263, the rotation and rotational speed adjusting operation of the boat 217 by the rotator 267, the lifting operation of the boat 217 by the boat elevator 115, and others.

The controller 121 may be configured by installing the aforementioned programs stored in the external memory 123 onto the computer. The external memory 123 includes, for example, a magnetic disk such as a HDD, an optical disk such as a CD, a magneto-optical disk such as a MO, a semiconductor memory such as a USB, and others. The memory 121c or the external memory 123 is configured as a non-transitory computer-readable recording medium storing the program. Hereinafter, these are collectively referred to simply as "recording medium." The term "recording medium" as used herein may refer to a case of solely including the memory 121c, a case of solely including the external memory 123, or a case of including both. In addition, providing the program to the computer may be done using communication means such as the Internet or a dedicated line without using the external memory 123.

### (2) Substrate Processing Process

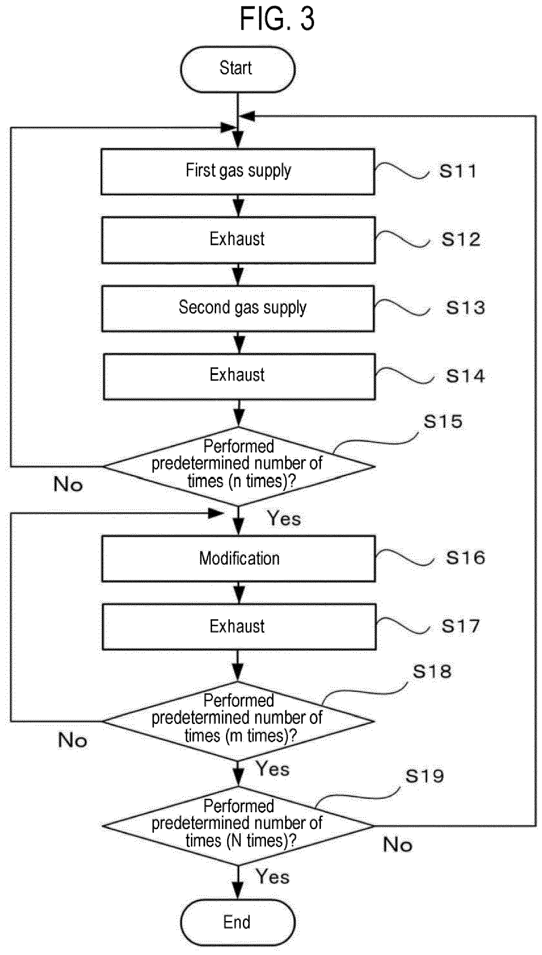

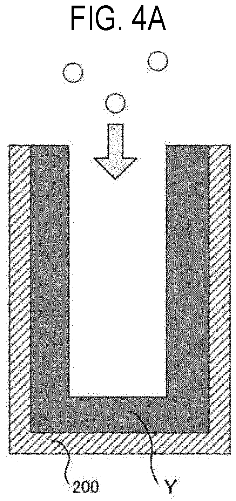

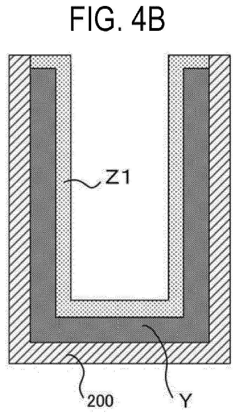

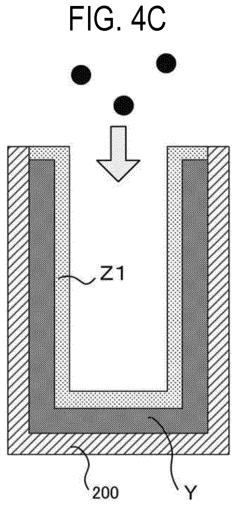

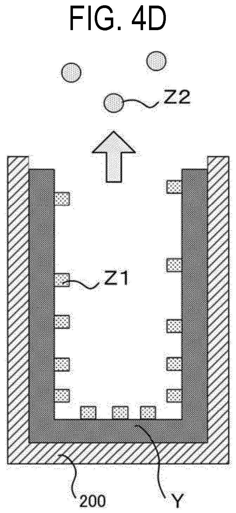

As a process of manufacturing semiconductor devices using the process furnace 202 of the substrate processing apparatus described above, an example of etching a substance Y containing an element X, which is formed on a surface of the wafer 200 in a recess, is described with reference to FIGS. 3 and 4. In the following description, the controller 121 is configured to be capable of controlling the operation of each component constituting the substrate processing apparatus.

The term "wafer" as used herein may refer to "a wafer itself" or "a stack including a wafer and a predetermined layer or film formed on a surface of the wafer." The term "a surface of a wafer" as used herein may refer to "a surface of a wafer itself" or "a surface of a predetermined layer or the like formed on a wafer." The expression "forming a predetermined layer on a wafer" as used herein may refer to "directly forming a predetermined layer on a surface of a wafer itself" or "forming a predetermined layer on top of a layer or the like formed on a wafer." The term "substrate" as used herein is equivalent to the term "wafer."

### (Wafer Charging and Boat Loading)

A plurality of wafers 200 at which the substance Y to be etched is formed are loaded onto the boat 217 (wafer charging). Thereafter, the boat 217 supporting the plurality of wafers 200 is lifted by the boat elevator 115 and is loaded into the process chamber 201 (boat loading). In this state, the seal cap 219 seals the lower end of the reaction tube 203 with the O-ring 220 interposed therebetween.

### (Pressure Regulation and Temperature Regulation)

The interior of the process chamber 201, i.e., a space where the wafer 200 exists, is vacuum-exhausted (decompression-exhausted) by the vacuum pump 246 to reach a desired processing pressure (degree of vacuum). Further, the wafers 200 in the process chamber 201 are heated by the heater 207 so as to reach a desired processing temperature. Further, rotation of the wafers 200 is initiated by the rotator 267. The operation of the vacuum pump 246 and the heating and rotation of the wafers 200 all continue at least until the wafers 200 are completely processed.

The processing temperature herein refers to a temperature of the wafer 200, or the temperature inside the process chamber 201, and the processing pressure refers to the pressure inside the process chamber 201. Further, a processing time refers to a time during which a processing is continued. This applies similarly to the following description.

Thereafter, the following steps S11 to S19 are performed on the substance Y formed on the wafer 200.

Herein, examples of the substance Y to be etched may include an oxide film, a nitride film, a carbide film, and the like. The oxide film may be, for example, at least one metal oxide film (oxide film containing a metal element) selected from the group of an aluminum oxide (Al₂O₃) film, zirconium oxide (ZrO₂) film, hafnium oxide (HfO₂) film, silicon oxide (SiO₂) film, titanium oxide (TiO₂) film, yttrium oxide (Y₂O₃) film, lanthanum oxide (La₂O₃) film, tantalum oxide (Ta₂O₅) film, niobium oxide (Nb₂O₅, Nb₂O₃, NbO) film, ruthenium oxide (RuO₂, RuO) film, vanadium oxide (V₂O₅) film, zinc oxide (ZnO) film, manganese oxide (MnO, Mn₂O₃) film, a cobalt oxide (CoO) film, and the like.

### (First Gas Supply, Step S11)

In this step, the first gas is supplied to the wafer 200 in the process chamber 201. Specifically, the valve 243a is opened to flow the first gas into the gas supply pipe 232a. The first gas is regulated in flow rate by the MFC 241a, is supplied into the process chamber 201 through the nozzle 249a, and is exhausted from the exhaust pipe 231. At this time, the valves 243c and 243d are opened to flow an inert gas into the gas supply pipes 232c and 232d.

In this step, as illustrated in FIG. 4A, the first gas containing the first halogen element is supplied to the wafer 200, which includes a surface of the substance Y containing the element X. Thus, as illustrated in FIG. 4B, for example, one atomic layer of the substance Y on the wafer 200 is modified into a first product Z1 containing the first halogen element and the element X so as to form the first product Z1 on the wafer 200.

It is desirable to perform this step under a condition where an amount of the first product Z1 being formed reaches saturation. In other words, in this step, it is desirable that the formation of the first product Z1 is self-controlled. In this case, a difference in the amount of the first product Z1 formed between an opening side and a deeper side of a recess of the wafer 200 may be reduced. This may improve uniformity of an etching amount within the recess of the wafer 200.

A processing condition when supplying the first gas in this step is exemplified as follows:
Processing temperature: 200 to 900 degrees C;
Processing Pressure: 10 to 7000 Pa;
Each gas supply time: 20 to 600 seconds; and
Partial pressure of first gas: 10 to 4,000 Pa.

In addition, the processing temperature is made substantially the same temperature in any of steps to be described later.

Further, if a supply flow rate includes 0 slm, "0 slm" refers to a case where none of a substance (gas) is supplied. This applies similarly to other descriptions of the present disclosure.

As for the first gas, for example, a F-containing gas that contains fluorine (F) as the first halogen element may be used. For example, at least one selected from the group of a fluorine (F₂) gas, nitrogen trifluoride (NF₃) gas, hydrogen fluoride (HF) gas, carbon tetrafluoride (CF₄) gas, tungsten hexafluoride (WF₆) gas, and the like may be used as the F-containing gas. Further, for example, a hydrogen compound may be used as the first gas. For example, a HF gas may be used as the hydrogen compound. One or more of these may be used as the first gas.

As for the inert gas, a nitrogen (N₂) gas or a noble gas such as an argon (Ar) gas, helium (He) gas, neon (Ne) gas, xenon (Xe) gas, or the like may be used. One or more of these may be used as the inert gas.

Specifically, for example, when the substance Y to be etched is an Al₂O₃ film and a HF gas is used as the first gas, the supply of HF gas causes the Al₂O₃ on the surface of the wafer 200 to react with the HF, resulting in detachment of some of Al and some of O from the Al₂O₃, which are then replaced by F, thereby converting the Al₂O₃ into AlOF and AlF₃. Further, the O detached from the Al₂O₃ combine with H to generate water vapor (H₂O gas). Then the H₂O is detached from the surface of the wafer 200 and is discharged from the process chamber 201, thus etching the surface of the Al₂O₃. In other words, the supply of HF gas causes the following reaction with the Al₂O₃ on the surface of the wafer 200, thereby forming an Al-F compound such as AlF₃, AlOF, or the like as the first product Z1 on the wafer 200.

Al₂O₃ + HF → AlF₃ + AlOF + H₂O

### (Exhaust, Step S12)

The valve 243a is closed to stop the supply of the first gas. At this time, the APC valve 244 of the exhaust pipe 231 remains open, and the interior of the process chamber 201 is vacuum-exhausted by the vacuum pump 246. Thus, a residual gas such as an unreacted first gas and a reaction by-product remaining on the wafer 200 and/or in the process chamber 201 is removed from the process chamber 201. At this time, the valves 243c and 243d may remain open to maintain the supply of inert gas into the process chamber 201, thereby allowing the interior of the process chamber 201 to be purged. The inert gas may act as a purge gas, improving the removal of the residual gas from the wafer 200. In this step, for example, an unreacted HF gas and the reaction by-product such as H₂O remaining in the process chamber 201 are removed from the interior of the process chamber 201.

After step S11, it is desirable to vacuum-exhaust and purge the interior of the process chamber 201, which is the space where the wafer 200 exists. This may reduce an amount of the first halogen element remaining on the wafer 200 after etching. In other words, it is possible to prevent deterioration in electrical characteristics of the wafer 200 due to the remaining first halogen element. The vacuum-exhaust and purge are performed, for example, 1 to 10 times.

At this time, it is desirable to make the processing time of this step longer than or equal to the processing time of the above-described step S11. This allows for the removal of, for example, the unreacted first gas, reaction by-products containing the first halogen element, a second product Z2 generated in step S13 to be described later, any substance containing the first halogen element, and others from the wafer 200. Accordingly, it is possible to reduce the amount of the first halogen element remaining on the wafer 200. In other words, it is possible to prevent the deterioration in the electrical characteristics of the wafer 200 due to the remaining first halogen element.

Further, at this time, it is desirable to make the processing pressure in this step greater than or equal to half of the processing pressure in the above-described step S11. This may reduce the amount of the first halogen element remaining on the wafer 200. In other words, it is possible to prevent the deterioration in the electrical characteristics of the wafer 200 due to the remaining first halogen element.

A condition for the vacuum-exhaust in this step is exemplified as follows:
Processing Pressure: 10 to 200 Pa; and
Processing time: 10 to 180 seconds.

A condition for purge in this step is exemplified as follows:
Processing Pressure: 10 to 7,000 Pa; and
Processing time: 30 to 180 seconds.

### (Second Gas Supply, Step S13)

Next, the second gas is supplied to the wafer 200 in the process chamber 201. Specifically, the valve 243b is opened to flow the second gas into the gas supply pipe 232b. The second gas is regulated in flow rate by the MFC 241b, is supplied into the process chamber 201 through the nozzle 249b, and is exhausted from the exhaust pipe 231. At this time, the valves 243c and 243d are opened to flow an inert gas into the gas supply pipes 232c and 232d.

In this step, as illustrated in FIG. 4C, the second gas containing the second halogen element is supplied to the wafer 200 where the first product Z1 formed on the surface thereof. Thus, as illustrated in FIG. 4D, at least a portion of the first product Z1 is converted into the second product Z2, which contains the element X and possesses a higher vapor pressure than the first product Z 1. In other words, in this step, at least a portion of the first product Z1 on the wafer 200 is removed.

It is desirable to perform this step under a condition where at least a portion of the substance Y is removable from the wafer 200 upon supplying the second gas to the substance Y that does not contain the first halogen element on the surface thereof. In other words, it is desirable to perform this step under a condition where the substance Y is etched by the second gas alone.

Generally, it is difficult for the second gas to reach the deeper side of the recess on the wafer 200 compared to the opening side. Therefore, the conversion from the first product Z1 to the second product Z2 is difficult to progress on the deeper side of the recess of the wafer 200. Since this step is performed under the condition where the substance Y is etched by the second gas alone, the substance Y on the opening side is expected to be etched by the second gas alone when attempting to convert the entire first product Z1 on the deeper side to the second product Z2. Accordingly, an etching amount of the substance Y on the opening side may become larger compared to the deeper side, potentially decreasing the uniformity of the etching amount within the recess of the wafer 200. In the embodiments, a portion of the first product Z1 may not be converted into the second product Z2 in this step. This may prevent the etching of the substance Y on the opening side by the second gas alone, thereby improving the uniformity of the etching amount within the recess on the wafer 200.

In this step, it is desirable to make an exposure amount of the second gas to the wafer 200 smaller than an exposure amount required to convert the entire first product Z1 on the wafer 200 to the second product Z2. This allows this step to be performed under a condition where at least a portion of the first product Z1 on the wafer 200 is not converted to the second product Z2. Herein, the "exposure amount of the second gas to the wafer 200" is calculated, for example, as "a value obtained from integrating a partial pressure of the second gas in the space where the wafer 200 exists at a certain point in time by a time from the start to the end of this step." Further, the "partial pressure of the second gas" is calculated, for example, as "a product of a mole fraction of the second gas and a (total) pressure in the space where the wafer 200 exists, at a certain point in time."

Therefore, for example, at least one selected from the group of the time (hereinafter also referred to as "supply time") during which the second gas is supplied to the wafer 200, the mole fraction of the second gas among the gases supplied to the wafer 200, and the pressure inside the process chamber 201 when supplying the second gas to the wafer 200 is made smaller than that in a case where the entire first product Z1 on the wafer 200 is converted into the second product Z2. As a result, the exposure amount of the second gas to the wafer 200 may be made smaller than the exposure amount required to convert the entire first product Z1 on the wafer 200 to the second product Z2.

The mole fraction of the second gas among the gases supplied to the wafer 200 may be controlled, for example, by a ratio of the flow rate of the second gas (also referred to as "supply flow rate of the second gas") supplied into the process chamber 201 and a flow rate of the inert gas (also referred to as "supply flow rate of the inert gas") in this step. For example, the supply flow rate of the second gas in this step may be made smaller than that in a case where the entire first product Z1 on the wafer 200 is converted into the second product Z2, and/or the supply flow rate of the inert gas in this step may be made larger than that in a case where the entire first product Z1 on the wafer 200 is converted into the second product Z2. This makes it possible to make the mole fraction of the second gas smaller than the mole fraction of the second gas required to convert the entire first product Z1 on the wafer 200 into the second product Z2.

Further, in this step, it is desirable to prioritize the conversion of the first product Z1 into the second product Z2 over the removal of the substance Y. This may prevent the etching of the substance Y on the opening side by the second gas alone, thereby improving the uniformity of the etching amount within the recess on the wafer 200.

A processing condition when supplying the second gas in this step is exemplified as follows:
Processing Pressure: 10 to 7000 Pa;
Each gas supply time: 60 to 600 seconds; and
Partial pressure of second gas: 10 to 4000 Pa.

As for the second gas, for example, a gas containing the second halogen element may be used. For example, a gas containing the second halogen element different from the first halogen element may be used as the second gas. Herein, it is desirable that an atomic number of the second halogen element contained in the second gas is greater than an atomic number of the first halogen element contained in the first gas. Specifically, for example, when the first halogen element is assumed to be F, the second halogen element contained in the second gas is assumed to be Cl. This makes it easier to perform this step under the condition where the substance Y is etched by the second gas alone.

As for the second gas, for example, a Cl-containing gas that contains chlorine (Cl) as the second halogen element may be used. For example, a chlorine (Cl₂) gas, boron trichloride (BCl₃) gas, carbon tetrachloride (CCl₄) gas, thionyl chloride (SOCl₂) gas, sulfuryl chloride (SO₂Cl₂) gas, phosgene (COCl₂) gas, phosphorus trichloride (PCl₃) gas, phosphorus pentachloride (PCl₅) gas, and the like may be used as the Cl-containing gas. Particularly, a SOCl₂ gas, a COCl₂ gas, and the like, which are gases containing oxygen (O), may be used as the Cl-containing gas. By using a gas that contains O, the O may be replaced with F, allowing the F to be detached from the wafer 200. Further, for example, compounds of group 13 elements or group 15 elements may be used as the second gas. For example, compounds of boron (B), aluminum (Al), gallium (Ga), indium (In), or the like may be used as the compounds of group 13 elements. For example, compounds of N, phosphorus (P), arsenic (As), or the like may be used as the compounds of group 15 elements. One or more of these may be used as the second gas.

For example, when a BCl₃ gas is used as the second gas, supplying the BCl₃ gas to the wafer 200 under the above-described condition causes AlF₃ on the surface of the wafer 200 to react with the BCl₃, resulting in the detachment and replacement of some of F from the AlF₃ by Cl. Thus, a molecular layer of AlF₃ formed on the surface of the wafer 200 is converted into volatile AlClₓF_{y}, which is then detached from the surface of the wafer 200. Further, the F detached from the AlF₃ combine with B detached from the BCl₃ to generate BF₂. Then, the AlClₓF_{y} and BF₂ are detached from the surface of the wafer 200 and are discharged from the process chamber 201, thereby etching the surface of Al₂O₃. In other words, the supply of BCl₃ gas initiates the following reaction on the surface of the wafer 200, where at least a portion of the first product Z1 is converted into the second product Z2 such as AlCl₃F, which contains the element X and possesses a higher vapor pressure than Al-F compounds such as ALF₃ and AlOF as the first product Z1. Then, the second product Z2 is detached from the surface of the wafer 200.

AlF₃ + AlOF + BCl₃ → AlCl₃F + BF₂ + AlOF

### (Exhaust, Step S14)

The valve 243b is closed to stop the supply of the second gas. At this time, the APC valve 244 of the exhaust pipe 231 remains open, and the interior of the process chamber 201 is vacuum-exhausted by the vacuum pump 246. Thus, a residual gas such as an unreacted second gas and a reaction by-product remaining on the wafer 200 and/or in the process chamber 201 is removed from the process chamber 201. At this time, the valves 243c and 243d may remain open to maintain the supply of inert gas into the process chamber 201, thereby allowing the interior of the process chamber 201 to be purged. In this step, for example, an unreacted BCl₃ gas and the reaction by-product such as AlCl₃F and BF₂ remaining in the process chamber 201 are removed from the interior of the process chamber 201.

After step S13, it is desirable to vacuum-exhaust and purge the interior of the process chamber 201. This allows for the removal of at least a portion of the first product Z 1, which contains the first halogen element, and the second product Z2 from the wafer 200. Accordingly, it is possible to reduce the amount of the first halogen element remaining on the wafer 200. In other words, it is possible to prevent the deterioration in the electrical characteristics of the wafer 200 due to the remaining first halogen element. The vacuum-exhaust and purge are performed, for example, 1 to 10 times.

At this time, it is desirable to make the processing time of this step longer than or equal to the processing time of the above-described step S13. This allows for the removal of at least a portion of the first product Z1, which contains the first halogen element, and the second product Z2 from the wafer 200. This may reduce the amount of the first halogen element remaining on the wafer 200 after etching. In other words, it is possible to prevent the deterioration in the electrical characteristics of the wafer 200 due to the remaining first halogen element.

Further, at this time, it is desirable to make the processing pressure in this step greater than or equal to half of the processing pressure in the above-described step S13. This allows for the removal of a substance containing the first halogen element and others from the wafer 200. This may reduce the amount of the first halogen element remaining on the wafer 200 after etching. In other words, it is possible to prevent the deterioration in the electrical characteristics of the wafer 200 due to the remaining first halogen element.

A condition for the vacuum-exhaust and purge in this step may be the same as that exemplified for the vacuum-exhaust and purge in step S12.

### (Performing Predetermined Number of Times, Step S15)

It is possible to remove (hereinafter also referred to as "etching") at least a portion of the substance Y on the wafer 200 by performing a cycle including steps S11 to S14 described above in this order a predetermined number of times (n times, where n is an integer greater than or equal to 1).

As described above, in the embodiments, step S13 is performed under the condition where at least a portion of the substance Y is removable from the wafer 200 when the second gas is supplied to the substance Y that does not contain the first halogen element on the surface thereof. In other words, step S13 is performed under the condition where the substance Y is etched by the second gas alone.

In this case, an amount of substance Y etched per cycle (hereinafter referred to as "etching rate") is likely to change linearly as a function of the number of etching cycles. This enables an accurate prediction of the amount of substance Y etched based on the number of cycles. For example, when the substance Y is a film, a thickness of an etched film is likely to increase linearly (or in a linearly proportional manner) as the number of cycles increases. In other words, it is possible to improve the controllability of the etching amount. Further, in this case, the conversion of the first product Z 1 into the second product Z2 tends to progress more easily in step S13. Accordingly, it is possible to enhance the number (throughput) of wafers 200 that may be processed per unit time.

As described above, once the first gas supply (step S11) to the performing of predetermined number of times (step S15) are performed, the first product Z 1 may remain on the wafer 200, and thus the first halogen element may remain in the film. In other words, the first halogen element may remain on the wafer 200. Therefore, a modification step S16 for removing the remaining first halogen element may be performed after the performing of the predetermined number of times (step S15) described above.

### (Modifying Agent Supply, Step S16)

Next, the modifying agent is supplied to the wafer 200 in the process chamber 201. Specifically, the valve 243e is opened to flow the modifying agent into the gas supply pipe 232a. The modifying agent is regulated in flow rate by the MFC 241e, is supplied into the process chamber 201 through the nozzle 249a, and is exhausted from the exhaust pipe 231. At this time, the valves 243c and 243d are opened to flow an inert gas into the gas supply pipes 232c and 232d.

By supplying the modifying agent, bonds between the substance Y and the first halogen element on the surface of the wafer 200 is broken, and the first halogen element is converted into a volatile, easily removable gas and is discharged from the process chamber 201. In other words, supplying the modifying agent to the wafer 200 converts at least a portion of the first product Z1 into a third product, which contains the element X and possesses a higher vapor pressure than the first product Z1. This may further reduce the amount of the first halogen element remaining on the wafer 200.

It is desirable to perform this step under the condition where at least a portion of the substance Y is removable from the wafer 200 when the modifying agent is supplied to the substance Y that does not contain the first halogen element on the surface thereof. This facilitates the conversion of the first product Z1 in this step, thereby enhancing the number (throughput) of wafers 200 that may be processed per unit time.

It is desirable that a reactivity of the modifying agent toward the substance Y and the first product Z1 is higher than a reactivity of the second gas toward the substance Y and the first product Z1. In this case, during the cycle including steps S11 to S14, it is easier to improve the uniformity of the etching amount within the recess of the wafer 200, while the conversion of the first product Z1 tends to less progress. Conversely, in this step, the conversion of the first product Z1, remaining on the wafer 200 after performing the cycle including steps S11 to S14, tends to progress more easily. Accordingly, it is possible to achieve both an improvement in the uniformity of the etching amount and a reduction in the amount of the first halogen element remaining on the wafer 200 after etching.

In this step, it is desirable to prioritize the conversion of the first product Z1 into the third product over the removal of the substance Y. This may prevent the etching of the substance Y on the opening side by the second gas alone, thereby improving the uniformity of the etching amount within the recess of the wafer 200.

The modifying agent may be in a liquid or gas phase. For example, a gas containing a third halogen element (also referred to as "third halogen element-containing gas"), the above-described second gas, an oxidizing agent (also referred to as "oxidizing gas"), a nitriding agent (also referred to as "nitriding gas"), and the like may be used as the modifying agent.

When the gas containing the third halogen element is used as the modifying agent, it is desirable that the atomic numbers of the second halogen element and the third halogen element are greater than the atomic number of the first halogen element. Specifically, for example, the halogen element contained in the first gas is assumed to be F, and the second and third halogen elements are assumed to be Cl. In this case, the gases exemplified as the second gas may be used as the modifying agent, or the gas used as the second gas in step S13 may be used as the modifying agent.

In this step, a processing condition when supplying the gas containing the third halogen element as the modifying agent is exemplified as follows:
Processing temperature: 200 to 900 degrees C;
Processing Pressure: 10 to 7000 Pa;
Each gas supply time: 60 to 600 seconds; and
Partial pressure of Modifying Agent: 10 to 4,000 Pa.

When the gas containing the third halogen element is used as the modifying agent in this step, it is desirable to increase an exposure amount of the gas containing the third halogen element to the wafer 200 in this step compared to the exposure amount of the second gas to the wafer 200 in step S13. In this case, during the cycle including steps S1 1 to S14, it becomes easier to improve the uniformity of the etching amount within the recess of the wafer 200, while the conversion of the first product Z1 tends to less progress. Conversely, in this step, the conversion of the first product Z 1 remaining on the wafer 200 after performing the cycle including steps S11 to S14 tends to progress more easily. Accordingly, it is possible to achieve both the improvement in the uniformity of the etching amount and the reduction in the amount of the first halogen element remaining on the wafer 200 after etching.

When the substance Y is an oxide, it is desirable to use an oxidizing agent as the modifying agent. When the substance Y is a nitride, it is desirable to use a nitriding agent as the modifying agent.

As for the oxidizing agent (oxidizing gas), for example, a gas containing oxygen (O) and hydrogen (H) may be used. For example, water vapor (H₂O gas), hydrogen peroxide (H₂O₂) gas, hydrogen (H₂) gas + oxygen (O₂) gas, H₂ gas + ozone (O₃) gas, and the like may be used as the O and H-containing gas. Further, in addition to the O and H-containing gas, for example, an oxygen (O) containing gas may be used as the oxidizing agent. For example, an O₂ gas, O₃ gas, nitrous oxide (N₂O) gas, nitrogen monoxide (NO) gas, nitrogen dioxide (NO₂) gas, carbon monoxide (CO) gas, carbon dioxide (CO₂) gas, and the like may be used as the O-containing gas. In addition, the O and H-containing gas is also a type of the O-containing gas. One or more of these may be used as the oxidizing agent. Further, as for the nitriding agent, for example, a hydrogen nitride-based gas may be used. For example, an ammonia (NH₃) gas, diazen (N₂H₂) gas, hydrazine (N₂H₄) gas, N₃H₈ gas, and the like may be used as the hydrogen nitride-based gas. One or more of these may be used as the nitriding agent. One or more of these gases activated by a plasma may be used as the oxidizing agent and the nitriding agent.

Further, when, for example, the O₃ gas as the oxidizing agent (oxidizing gas) is used as the modifying agent, supplying the O₃ gas to the wafer 200 causes AlOF on the surface of the wafer 200 to react with the O₃, resulting in a breakage of the bond between F and AlOF. Then, the F is detached from the AlOF and is replaced by O. This modifies the AlOF formed on the wafer 200 into Al₂O₃, resulting in a detachment of FX. In other words, the FX is detached from the surface of the wafer 200 and is discharged from the interior of the process chamber 201, resulting in the removal of residual F. This allows etching for each F-containing layer, thus ensuring the removal of F. The following reaction occurs between the AlOF and the O₃ gas supplied to the surface of the wafer 200.

AlOF + O₃ → Al₂O₃ + FX

In this step, a processing condition when supplying the oxidizing gas as the modifying agent is exemplified as follows:
Processing temperature: 200 to 900 degrees C;
Processing Pressure: 10 to 200 Pa; and
Each gas supply time: 0.1 to 300 seconds.

### (Exhaust, Step S17)

The valve 243e is closed to stop the supply of the modifying agent. At this time, the APC valve 244 of the exhaust pipe 231 remains open, and the interior of the process chamber 201 is vacuum-exhausted by the vacuum pump 246. Thus, a residual gas such as an unreacted modifying agent and a reaction by-product remaining on the wafer 200 and/or in the process chamber 201 is removed from the process chamber 201. At this time, the valves 243c and 243d may remain open to maintain the supply of inert gas into the process chamber 201, thereby allowing the interior of the process chamber 201 to be purged.

A condition for the vacuum-exhaust and purge in this step may be the same as that exemplified for the vacuum-exhaust and purge in step S12.

### (Performing Predetermined Number of Times, Step S18)

A cycle including steps S16 and S17 described above is performed a predetermined number of times (m times, where m is an integer greater than or equal to 1). For example, when a gas containing a halogen element is used as the modifying agent, m ranges from 1 to 50. For example, when an oxidizing gas or nitriding gas is used as the modifying agent, m ranges from 60 to 300.

### (Performing Predetermined Number of Times, Step S19)

A cycle including steps S11 to S18 described above is performed a predetermined number of times (N times, where n is an integer greater than or equal to 1). For example, N ranges from 1 to 100.

### (After-Purge and Atmospheric Pressure Recovery)

An inert gas is supplied into the process chamber 201 from each of the gas supply pipes 232c and 232d, and is discharged from the exhaust pipe 231. Thus, the interior of the process chamber 201 is purged, and any gas and reaction by-product remaining in the process chamber 201 are removed from the interior of the process chamber 201 (after-purge). Subsequently, the atmosphere within the process chamber 201 is replaced by the inert gas (inert gas replacement), and the pressure inside the process chamber 201 is restored to normal pressure (atmospheric pressure recovery).

### (Boat Unloading and Wafer Discharge)

Thereafter, the seal cap 219 is lowered by the boat elevator 115 to open the lower end of reaction tube 203. Then, the processed wafer 200 is unloaded from the lower end of the reaction tube 203 to the outside of the reaction tube 203 while being supported by the boat 217 (boat unloading). The processed wafer 200 is taken out from the boat 217 (wafer discharge).

### <Other Embodiments of Present Disclosure>

Embodiments of the present disclosure are specifically described above. However, the present disclosure is not limited to the above-described embodiments, but may be changed in various ways without departing from the gist of the present disclosure.

### (Modification)

This modification involves a difference in the second gas supply (step S13) of the substrate processing process described above. In this modification, in addition to achieving effects similar to those in the above-described embodiments, the effects described below are obtained.

In this modification, the above-described second gas supply (step S13) involves supplying the second gas to the wafer 200 multiple times and exhausting the interior of the process chamber 201 during the supply of the second gas. In other words, a cycle involving the supply of the second gas and the removal of the second product Z2 by exhaust is performed multiple times. That is, the second gas is pulse-supplied. In other words, the second gas is supplied intermittently. This may make it difficult for the second product Z2 produced by the supply of the second gas to be re-adsorbed onto the wafer 200, thereby achieving a reduction in the amount of the first halogen element remaining on the wafer 200. Accordingly, this may further enhance the characteristics of the substance Y such as the electrical characteristics.

As for the exhaust in this step, purge and vacuum-exhaust of the process chamber 201 may be performed, or one of these may be performed. As for the exhaust in this step, it is desirable to perform the vacuum-exhaust of the interior of the process chamber 201 alone. This may improve throughput while reducing the amount of the first halogen element remaining on the wafer 200.

A processing condition in step S13 of this modification is exemplified as follows:
Processing Pressure: 10 to 7,000 Pa;
Each gas supply time: 20 to 600 seconds;
Partial pressure of second gas: 10 to 4,000 Pa;
Number of times second gas is supplied: 2 to 10 times;
Exhaust time: 10 to 180 seconds; and
Processing pressure during exhaust: 10 to 200 Pa.

### (Other Embodiments)

The above description is made using a case where at least a portion of the substance Y on the wafer 200 is etched by performing a process from the first gas supply (step S 11) to the performing of predetermined number of times (step S19). The present disclosure is not limited to this, and it is possible to improve the controllability of etching of the substance Y on the wafer 200 even when a process from the first gas supply (step S 11) to the performing of predetermined number of times (step S15) is performed. In other words, in this embodiment as well, effects similar to those in the above-described embodiments are obtained.

Further, the above embodiments are described using a case where step S11 is performed under the condition where the amount of the first product Z1 formed reaches saturation. The present disclosure is not limited to this, and step S11 may also be performed under a condition where the amount of the first product Z 1 formed is not saturated. In other words, in step S11, the formation of the first product Z 1 may not be self-controlled. In this embodiment as well, effects similar to those in the above-described embodiments are obtained. Further, in this embodiment, the time required for step S11 may be further shortened.

Further, the above embodiments are described using a case where a process from the first gas supply (step S11) to the performing of predetermined number of times (step S19) is performed continuously within the same process furnace 202 (in situ), but the present disclosure is not limited to this, and a process from the first gas supply (step S11) to the performing of predetermined number of times (step S15) and a process from the modification (step S16) to the performing of predetermined number of times (step S18) may be performed in different process furnaces (ex situ). In this embodiment as well, effects similar to those in the above-described embodiments are obtained.

Further, in the above description, the etching of the substance Y formed on the wafer 200 is described by way of example. However, the present disclosure is not limited to this. For example, it may also be suitably applied to an etching of the substance Y formed on an inner wall of the process chamber 201 or a surface of the boat 217 and the like (cleaning within the process chamber 201). In this embodiment as well, effects similar to those in the above-described embodiments are obtained.

Further, recipes used for substrate processing may be individually prepared according to processing contents and may be stored in the memory 121c via an electric communication line or the external memory 123. Then, when initiating the substrate processing, it is desirable for the CPU 121a to select an appropriate recipe from among the multiple recipes stored in the memory 121c based on the processing contents. This allows for formation of various types of films, composition ratios, qualities, and film thicknesses, in the substrate processing apparatus, with enhanced reproducibility. Further, it reduces operator's burden, enabling quick initiation of the substrate processing while avoiding operational errors.

The above-described recipes are not limited to newly-created ones but may be prepared, by modifying existing recipes already installed in the substrate processing apparatus, for example. When modifying the recipes, the modified recipes may be installed in the substrate processing apparatus via electrical communication lines or a recording medium storing the recipes. Further, the existing input/output device 122 of the substrate processing apparatus may be operated to directly modify the existing recipes already installed in the substrate processing apparatus.

In the above-described embodiments, an example of using a batch-type substrate processing apparatus that processes multiple substrates at once is described. The present disclosure is not limited to the above-described embodiments. For example, it may also be suitably applied to a single wafer type substrate processing apparatus that processes one or several substrates at a time. Further, in the above-described embodiments, an example of using a substrate processing apparatus equipped with a hot-wall type process furnace is described. The present disclosure is not limited to the above-described embodiments. For example, it may also be suitably applied even when using a substrate processing apparatus equipped with a cold-wall type process furnace.

Even when using such a substrate processing apparatus, it is possible to perform film formation using the same processing procedures and processing conditions as those in the above-described embodiments, thereby achieving effects similar to those in the above-described embodiments.

Further, the above-described embodiments and modifications may be combined as appropriate. The processing procedures and processing conditions at this time may be the same as the processing procedures and processing conditions in the above-described embodiments and modifications, for example.

According to the present disclosure, it is possible to improve controllability of an etching amount.

While certain embodiments are described, these embodiments are presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200), comprising:
removing a portion of a substance Y from the substrate (200) by performing a cycle a predetermined number of times, the cycle including:
(a1) supplying a first gas containing a first halogen element to the substrate (200), which includes a surface of the substance Y containing an element X, to form a first product, which contains the first halogen element and the element X, on the substrate (200); and
(b1) supplying a second gas containing a second halogen element to the substrate (200) to convert at least a portion of the first product into a second product containing the element X and having a higher vapor pressure than the first product,
wherein (b1) is performed under a condition in which at least a portion of the substance Y is removable from the substrate (200) when the second gas is supplied to the substance Y that does not contain the first halogen element on the surface.

2. The method of claim 1, wherein in (b1), a portion of the first product is not converted into the second product.

3. The method of claim 2, wherein in (b1), an exposure amount of the second gas to the substrate (200) is made smaller than an exposure amount at which all of the first product on the substrate (200) is converted into the second product.

4. The method of claim 1, wherein (a1) is performed under a condition where an amount of the first product formed reaches saturation.

5. The method of claim 1, wherein the cycle further includes at least one selected from the group of:
(a2) performing vacuum-exhaust and purge in a space where the substrate (200) exists after (a1), and
(b2) performing vacuum-exhaust and purge in a space where the substrate (200) exists after (b 1).

6. The method of claim 1, wherein the cycle further includes at least one selected from the group of:
(a2) performing exhaust in a space where the substrate (200) exists for a time longer than or equal to a time for performing (a1), after (a1), and
(b2) performing exhaust in a space where the substrate (200) exists for a time longer than or equal to a time for performing (b 1), after (b 1).

7. The method of claim 1, in addition to the cycle, further comprising:
(c) supplying a modifying agent to the substrate (200) to convert at least a portion of the first product into a third product containing the element X and having a higher vapor pressure than the first product.

8. The method of claim 7, wherein (c) is performed under a condition in which at least a portion of the substance Y is removable from the substrate (200) when the modifying agent is supplied to the substance Y that does not contain the first halogen element on the surface.

9. The method of claim 8, wherein a reactivity of the modifying agent to the substance Y and the first product is higher than a reactivity of the second gas to the substance Y and the first product.

10. The method of claim 8, wherein the modifying agent is a third halogen element-containing gas.

11. The method of claim 10, wherein an exposure amount of the third halogen element-containing gas to the substrate (200) in (c) is greater than an exposure amount of the second gas to the substrate (200) in (b1).

12. The method of claim 1, wherein an atomic number of the second halogen element is greater than an atomic number of the first halogen element.

13. A method of manufacturing a semiconductor device comprising the method of claim 1.

14. A substrate processing apparatus, comprising:
a first gas supply system configured to supply a first gas containing a first halogen element to a substrate (200) including a surface of a substance Y containing an element X;
a second gas supply system configured to supply a second gas containing a second halogen element to the substrate (200); and
a controller (121) configured to be capable of controlling the first gas supply system and the second gas supply system to perform a process of removing a portion of the substance Y from the substrate (200) by performing a cycle a predetermined number of times, the cycle including:
(a1) supplying the first gas to the substrate (200) to form a first product, which contains the first halogen element and the element X, on the substrate (200); and
(b1) supplying the second gas to the substrate (200) to convert at least a portion of the first product into a second product containing the element X and having a higher vapor pressure than the first product,
wherein (b1) is performed under a condition in which at least a portion of the substance Y is removable from the substrate (200) when the second gas is supplied to the substance Y that does not contain the first halogen element on the surface.

15. A program that causes, by a computer, a substrate processing apparatus to perform a process comprising:
removing a portion of a substance Y from a substrate (200) by performing a cycle a predetermined number of times, the cycle including:
(a1) supplying a first gas containing a first halogen element to the substrate (200), which includes a surface of the substance Y containing an element X, to form a first product, which contains the first halogen element and the element X, on the substrate (200); and
(b 1) supplying a second gas containing a second halogen element to the substrate (200) to convert at least a portion of the first product into a second product containing the element X and having a higher vapor pressure than the first product,
wherein (b 1) is performed under a condition in which at least a portion of the substance Y is removable from the substrate (200) when the second gas is supplied to the substance Y that does not contain the first halogen element on the surface.
